(19) Europäisches Patentamt
European Patent Office
Office européen des brevets

(11) **EP 4 764 408 A1**

(12) **DEMANDE DE BREVET EUROPEEN**

(43) Date de publication:
**24.06.2026 Bulletin 2026/26**

(51) Classification Internationale des Brevets (IPC):
***G01C 17/38*** (2006.01)       ***G01C 21/16*** (2006.01)
***G01R 33/00*** (2006.01)

(21) Numéro de dépôt: **25225152.5**

(22) Date de dépôt: **18.12.2025**

(52) Classification Coopérative des Brevets (CPC):
**G01C 17/38; G01C 21/1654; G01R 33/0035**

(84) Etats contractants désignés:
**AL AT BE BG CH CY CZ DE DK EE ES FI FR GB GR HR HU IE IS IT LI LT LU LV MC ME MK MT NL NO PL PT RO RS SE SI SK SM TR**
Etats d'extension désignés:
**BA**
Etats de validation désignés:
**GE KH LA MA MD TN**

(30) Priorité: **19.12.2024 FR 2414618**

(71) Demandeur: **THALES**
**92190 Meudon (FR)**

(72) Inventeurs:
• **RAIS ALI, Mehdi**
**92622 GENEVILLIERS CEDEX (FR)**
• **BROUSSARD, Elliot**
**92622 GENEVILLIERS CEDEX (FR)**

(74) Mandataire: **Lavoix**
**2, place d'Estienne d'Orves**
**75441 Paris Cedex 09 (FR)**

(54) **PROCÉDÉ DE CALIBRATION D'UN MAGNETOMÈTRE D'UN DISPOSITIF DE POSITIONNEMENT D'UNE CHARGE UTILE, PROCÉDÉ DE POINTAGE D'UNE CHARGE UTILE, DISPOSITIF DE POSITIONNEMENT ET SYSTÈME ANTENNAIRE CORRESPONDANTS**

(57) La présente invention concerne un procédé de calibration (100) d'un magnétomètre (5) d'un dispositif de positionnement (1) comprenant un module de positionnement (7) configuré pour contrôler une orientation d'une charge utile (3). Le procédé comprend a) pour une position de calibration (Ocal) donnée d'un point de référence (O) du dispositif de positionnement (1) dans un référentiel principal, et pour chacune d'une pluralité de directions de calibration (Dcal,k) d'un axe de référence (AA') : la transmission (105k) au module de positionnement (7) d'instructions de positionnement de l'axe de référence (AA') selon la direction de calibration (Dcal,k), l'acquisition (110k) au moyen du magnétomètre (5) d'un premier vecteur représentatif d'une direction du vecteur champ magnétique terrestre à la position de calibration (Ocal) et la détermination (120k), sur la base de données de mesures auxiliaires obtenues avec un dispositif de mesure auxiliaire (65), d'un vecteur de référence respectif représentatif de la direction du vecteur champ magnétique terrestre à la position de calibration (Ocal) ; b) la détermination (130) d'un modèle de calibration du magnétomètre (5) sur la base de l'ensemble des premiers vecteurs et des vecteurs de référence respectifs ; et c) la calibration (140) du magnétomètre (5) sur la base du modèle de calibration.

FIG.3

**Description**

La présente invention concerne un procédé de calibration d'un magnétomètre d'un dispositif de positionnement d'une charge utile, notamment telle qu'une antenne d'un système antennaire de réception et/ou d'émission de signaux électromagnétiques.

L'invention concerne aussi un procédé de pointage d'une charge utile au moyen de ce dispositif de positionnement, en particulier d'une telle antenne. L'invention concerne en outre un dispositif de positionnement pour la mise en œuvre du procédé de calibration et un système antennaire pour la mise en œuvre du procédé de pointage ainsi qu'un véhicule équipé d'un tel système antennaire.

Les systèmes antennaires de réception et/ou d'émission de signaux électromagnétiques sont mis en œuvre dans de nombreux domaines, en particulier le domaine des télécommunications.

Pour assurer une bonne réception d'un signal, il est nécessaire de pointer l'antenne de ces systèmes antennaires dans une direction fonction de la source du signal à recevoir.

A cette fin, un système antennaire peut comprendre un dispositif de positionnement de son antenne.

Un tel dispositif de positionnement peut être configuré pour permettre que l'antenne pointe automatiquement sur une source de signal, par exemple un satellite de télécommunication, quelle que soit la position du satellite dans le ciel.

Un dispositif de positionnement est par exemple utile lorsqu'une antenne au sol doit suivre la direction de satellites en orbite non géostationnaire, ou encore lorsque l'antenne est embarquée sur un véhicule mobile devant assurer le maintien d'une liaison de communication avec un satellite donné, géostationnaire ou non.

Le dispositif de positionnement peut contrôler l'orientation de l'antenne sur la base de données de mesure de direction fournies par un capteur approprié, par exemple un dispositif gyrolaser.

Les dispositifs gyrolaser permettent un positionnement de la direction de pointage de l'antenne avec une précision de l'ordre du dixième de degré et sont résistants au brouillage. Toutefois, ces dispositifs sont très coûteux et relativement encombrants, de sorte qu'ils peuvent être inadaptés pour certaines applications pour lesquelles les contraintes d'encombrement et/ou de coût sont prioritaires.

De manière alternative, il est connu d'utiliser des données de mesures de systèmes de navigation inertielle intégrant un récepteur GNSS multi-bandes (en anglais, « dual GNSS » ou « triple band GNSS ») pour ajuster la direction de pointage de l'antenne. Ces systèmes permettent une précision de détermination d'un cap « vrai » (c'est-à-dire de l'angle entre la direction du Nord géographique et la direction de pointage) assez élevée, de l'ordre de quelques dixièmes de degrés. Toutefois, ces systèmes sont sensibles au brouillage.

De telles solutions ne sont donc pas adaptées aux systèmes antennaires pour lesquelles des contraintes d'encombrement sont à respecter et nécessitant une sensibilité au brouillage réduite.

Dans de tels cas, il est connu de contrôler la direction de pointage de l'antenne sur la base de mesures magnétométriques permettant de déterminer un cap magnétique, c'est-à-dire l'angle entre la direction de pointage et le Nord magnétique.

Les magnétomètres présentent en effet l'avantage d'être à la fois peu encombrants et peu sensibles au brouillage.

Toutefois, la mesure effectuée par un magnétomètre peut être perturbée par son environnement direct.

En particulier, un magnétomètre monté à bord d'un véhicule est soumis à :

- des perturbations dues à la présence de matériaux ferromagnétiques doux à proximité du magnétomètre ;
- des perturbations dues à la présence matériaux ferromagnétiques durs et/ou de conducteurs électriques parcourus par des courants continus à proximité du magnétomètre ; et
- des perturbations associées aux courants de Foucault créés par des variations de flux magnétiques dans les structures métalliques du véhicule.

La mesure effectuée par le magnétomètre peut en outre être entachée de diverses erreurs systématiques, par exemple liées aux tolérances sur le positionnement du magnétomètre sur le véhicule ou sur la chaîne de mesure du magnétomètre.

Différentes méthodes de calibration du magnétomètre permettant de réduire les erreurs de mesure sont connues.

Par exemple, dans le cas où le système de positionnement est placé sur ou intégré dans un véhicule, il est connu de réaliser une série de mouvements avec l'antenne et/ou avec le véhicule de manière à acquérir des données de calibration pour des positions spécifiques du magnétomètre.

Ces méthodes réduisent le temps de disponibilité opérationnelle du véhicule dans le cas où elles sont fondées sur des mouvements du véhicule.

Dans le cas où l'orientation de l'antenne est modifiée relativement au véhicule, ces méthodes ne peuvent être mises en œuvre que si toutes les directions de l'espace sont accessibles à l'antenne, ce qui n'est souvent pas possible du fait de la configuration du véhicule.

Le document "Explicit Solution for Magnetometer Calibration", E. M. Hemerly and F. A. A. Coelho, IEEE Transactions on Instrumentation and Measurement, vol. 63, no. 8, pp. 2093-2095, Aug. 2014, décrit une méthode de calibration dans laquelle un magnétomètre est positionné selon une pluralité de directions de pointage pour chacune desquelles une mesure du vecteur champ magnétique terrestre est effectuée. Une matrice de calibration est alors déterminée par comparaison du vecteur champ magnétique mesuré dans chacune des directions de pointage avec le vecteur champ magnétique terrestre attendu, de norme supposée constante.

Toutefois, cette méthode de calibration se fonde sur l'hypothèse que l'intensité du vecteur champ magnétique terrestre est constante et égale à une valeur de référence prédéterminée.

La calibration du magnétomètre obtenue par ce procédé de l'art antérieur n'est donc valable que si la valeur de référence choisie est suffisamment proche de l'intensité du champ magnétique terrestre sur le lieu d'utilisation du magnétomètre.

Une telle méthode de calibration n'est donc pas adaptée pour des systèmes antennaires mobiles, notamment pour des systèmes antennaires équipant des véhicules, pour lesquels une calibration serait nécessaire, et serait effectuée sur une portion de l'espace incomplète, donc insuffisamment riche, et/ou avec des mouvements du véhicule.

Un but de l'invention est alors de proposer un procédé de calibration d'un magnétomètre d'un dispositif de positionnement d'une charge utile, notamment de l'antenne d'un système antennaire de réception et/ou d'émission de signaux électromagnétiques, qui soit rapide à mettre en œuvre et de précision améliorée.

A cet effet, l'invention a pour objet un procédé de calibration d'un magnétomètre d'un dispositif de positionnement d'une charge utile, le dispositif de positionnement comprenant un module de positionnement configuré pour contrôler une orientation de la charge utile relativement à un référentiel principal à partir de données fournies par le magnétomètre, le procédé comprenant :

a) pour une position de calibration donnée d'un point de référence du dispositif de positionnement dans le référentiel principal, et pour chacune d'une pluralité de directions de calibration d'un axe de référence du dispositif de positionnement :

- la transmission au module de positionnement d'instructions de positionnement de l'axe de référence selon la direction de calibration,
- l'acquisition au moyen d'un élément sensible magnétomètre d'un premier vecteur représentatif d'une direction du vecteur champ magnétique terrestre à la position de calibration, l'axe de référence étant orienté selon la direction de calibration, et
- la détermination, sur la base de données de mesures auxiliaires obtenues avec un dispositif de mesure auxiliaire, d'un vecteur de référence respectif représentatif de la direction du vecteur champ magnétique terrestre à la position de calibration,

b) la détermination d'un modèle de calibration du magnétomètre sur la base de l'ensemble des premiers vecteurs et des vecteurs de référence respectifs obtenus pour chacune des directions de calibration,

le modèle de calibration étant configuré pour fournir un vecteur corrigé, représentatif d'une direction du vecteur champ magnétique terrestre pour une position de mesure quelconque du point de référence à partir d'un vecteur mesuré acquis au moyen de l'élément sensible du magnétomètre et représentatif d'une direction du vecteur champ magnétique terrestre à la position de mesure,
le point de référence étant alors dans la position de mesure et l'axe de référence étant alors selon une direction de mesure quelconque, et

c) la calibration du magnétomètre sur la base du modèle de calibration, le vecteur corrigé étant alors fourni en sortie du magnétomètre.

Le procédé de calibration selon l'invention se base sur des données de mesures auxiliaires représentatives de la direction du champ magnétique terrestre à la position géographique de calibration. Ces données de mesure sont obtenues avec un dispositif de mesure auxiliaire, de sorte qu'il ne nécessite aucune hypothèse préalable sur le caractère uniforme de l'intensité du champ magnétique terrestre.

Le dispositif de mesure auxiliaire peut être fondé sur un principe physique partiellement ou totalement différent de celui du magnétomètre, de sorte qu'il peut ne pas être sensible ou être moins sensible aux perturbations qui affectent le magnétomètre.

Le vecteur de référence fournit un élément de comparaison pour le premier vecteur respectif, permettant de quantifier les perturbations subies par le magnétomètre pour chacune des directions de calibration respectives.

Le balayage d'une pluralité de directions de calibration et la comparaison des premiers vecteurs mesurés avec les vecteurs de référence respectifs permettent donc de prendre en compte les anisotropies magnétiques de l'environnement immédiat du dispositif de positionnement et de la charge utile lorsqu'elle est couplée à ce dispositif, notamment d'une antenne d'un système antennaire, dans le modèle de calibration, en particulier d'un véhicule sur ou dans lequel la charge utile est installée.

Le dispositif de mesure auxiliaire peut être utilisé uniquement pour la calibration et est alors indépendant de la charge utile, notamment d'une antenne d'un système antennaire. Dans ce cas, il est possible de choisir un dispositif de mesure auxiliaire de grande précision, indépendamment de toute contrainte d'encombrement. La calibration peut alors par exemple être effectuée lors de l'installation de la charge utile, en particulier du type antenne d'un système antennaire, sur un véhicule et/ou lors d'une opération de maintenance de ce véhicule.

Alternativement, le dispositif de mesure auxiliaire peut être intégré à un système comprenant la charge utile, en particulier à un système antennaire. En particulier, le dispositif de mesure auxiliaire peut comprendre une antenne d'un système antennaire, l'antenne étant alors la charge utile.

Dans ce cas, la calibration peut être effectuée, une seule fois ou de manière itérative, lorsqu'un signal satellitaire est reçu.

Le procédé selon l'invention est donc facile à mettre en œuvre, notamment dans un véhicule dont est équipé la charge utile couplée au dispositif de positionnement sans que des mouvements du véhicule soient nécessaires. Ce procédé permet une calibration de grande précision du magnétomètre, tenant compte des sources de perturbations magnétiques présentes dans l'environnement immédiat du dispositif de positionnement, et cela sans nécessiter d'hypothèse a priori sur le champ magnétique terrestre local au niveau de la position géographique de calibration.

Suivant d'autres aspects avantageux de l'invention, le procédé de calibration comprend une ou plusieurs des caractéristiques suivantes, prises isolément ou suivant toutes les combinaisons techniquement possibles :

- le dispositif de positionnement est configuré pour équiper un véhicule et le module de positionnement est configuré pour contrôler une orientation, relativement au référentiel principal, de la charge utile lorsque cette charge utile est couplée au dispositif de positionnement, à partir de données fournies par le magnétomètre ;
- le magnétomètre est solidaire de l'axe de référence du dispositif de positionnement, de même que la charge utile lorsqu'elle est couplée au dispositif de positionnement ;
- le dispositif de mesure auxiliaire est un récepteur de signaux de navigation par satellites, les mesures auxiliaires étant obtenues au moyen dudit récepteur de signaux de navigation et/ou de positionnement par satellites ;
- le dispositif de mesure auxiliaire est une centrale de navigation inertielle ;
- la charge utile est une antenne de télécommunication, le dispositif de mesure auxiliaire comprenant ladite antenne ;
- les directions de calibration sont équidistribuées dans un angle solide accessible à l'axe de référence (AA').
- la détermination du modèle de calibration comprend la détermination d'une matrice de calibration et un vecteur de calibration tels que le vecteur corrigé et le vecteur mesuré sont liés par une équation de la

forme :

$$\overrightarrow{b_{corr}} = H_{cal} \; \overrightarrow{b_{mes}} + \overrightarrow{L_{cal}}$$

où $\overrightarrow{b_{corr}}$ désigne le vecteur corrigé, $\overrightarrow{b_{mes}}$ désigne le vecteur mesuré, $H_{cal}$ désigne la matrice de calibration et $\overrightarrow{L_{cal}}$ désigne le vecteur de calibration.

L'invention concerne également un procédé de pointage d'une charge utile couplée à un dispositif de positionnement comprenant un magnétomètre et un module de positionnement configuré pour contrôler l'orientation de la charge utile relativement à un référentiel principal à partir de données issues de mesures du magnétomètre, le procédé de pointage comprenant :

i) la calibration du magnétomètre selon le procédé de calibration tel que décrit précédemment,
ii) le positionnement du point de référence du dispositif de positionnement dans une position de pointage,
iii) la fourniture d'une direction de pointage de la charge utile,
iv) le positionnement de l'axe de référence du dispositif de positionnement selon la direction de pointage sur la base d'un vecteur corrigé fourni par le magnétomètre à partir d'un vecteur mesuré respectif acquis au moyen de l'élément sensible du magnétomètre, le point de référence étant pour cette acquisition à la position de pointage et l'axe de référence étant dans une direction de mesure quelconque.

Suivant d'autres aspects avantageux de l'invention, le procédé de pointage comprend une ou plusieurs des caractéristiques suivantes, prises isolément ou suivant toutes les combinaisons techniquement possibles :

- le dispositif de positionnement équipe un véhicule ;
- le magnétomètre et la charge utile sont solidaires de l'axe de référence pour la calibration du magnétomètre, ainsi que pour les étapes ultérieures du procédé de pointage
- la charge utile est une antenne d'un système antennaire de télécommunication et la fourniture de la direction de pointage de la charge utile comprend la fourniture d'un azimut d'un satellite de télécommunication.

L'invention concerne également un dispositif de positionnement d'une charge utile, configuré pour contrôler une orientation de la charge utile relativement à un référentiel lorsque la charge utile est couplée au dispositif de positionnement, le dispositif de positionnement comprenant :

- un magnétomètre, et

- un module de positionnement configuré pour contrôler l'orientation de la charge utile qui serait couplée au dispositif de positionnement relativement à un référentiel principal à partir de données issues de mesures du magnétomètre,

le dispositif de positionnement étant en outre configuré pour mettre en œuvre le procédé de calibration tel que décrit précédemment.

Suivant d'autres aspects avantageux de l'invention, le dispositif de positionnement comprend une ou plusieurs des caractéristiques suivantes, prises isolément ou suivant toutes les combinaisons techniquement possibles :

- le dispositif de positionnement est configuré pour équiper un véhicule ;
- le magnétomètre est solidaire d'un axe de référence du dispositif de positionnement et le module de positionnement est configuré pour contrôler, relativement à un référentiel principal, l'orientation de la charge utile lorsqu'elle est couplée au dispositif de positionnement de manière à être solidaire de l'axe de référence, à partir de données issues de mesures du magnétomètre.

L'invention concerne en outre un système antennaire configuré pour la réception et/ou l'émission de signaux électromagnétiques comprenant une antenne et un dispositif de positionnement tel que décrit précédemment auquel l'antenne est couplée en tant que charge utile.

L'invention concerne également un véhicule équipé d'un tel système antennaire de réception et/ou d'émission de signaux électromagnétiques.

L'invention apparaîtra plus clairement à la lecture de la description qui va suivre, donnée uniquement à titre d'exemple non limitatif, et faite en référence aux dessins dans lesquels :

la figure 1 est une représentation schématique d'un véhicule équipé d'un système antennaire selon l'invention ;

la figure 2 représente les angles d'élévation et d'azimut permettant de repérer la position angulaire de l'antenne du système antennaire de la figure 1 ;

la figure 3 représente les étapes du procédé de pointage du système antennaire de la figure 1 sous forme de logigramme ; et

la figure 4 représente la différence entre le résultat d'une mesure de cap magnétique effectuée avec un magnétomètre calibré avec le procédé selon l'invention (courbe en trait plein) et la même mesure effectuée avec une centrale de navigation inertielle basée sur un gyrolaser, fournissant un cap à 0,1° près, en fonction du temps l'axe de référence étant déplacé au cours du temps dans l'ensemble de la gamme de positions qui lui sont accessibles.

L'invention porte sur un dispositif de positionnement 1 d'une charge utile 3.

Le dispositif de positionnement 1 est configuré pour contrôler une orientation de la charge utile 3 relativement à un référentiel lorsqu'une telle charge utile 3 est couplée au dispositif de positionnement 1, à partir de données fournies par un magnétomètre 5 du dispositif de positionnement 1.

Le dispositif de positionnement 1 comprend le magnétomètre 5, qui est mécaniquement solidaire de la charge utile 3 lorsque la charge utile 3 est couplée au dispositif de positionnement 1, et un module de positionnement 7 configuré pour contrôler une orientation de la charge utile 3 relativement à un référentiel principal sur la base de données de mesure fournies par le magnétomètre 5 lorsque la charge utile 3 est couplée au dispositif de positionnement 1.

La charge utile 3 est un objet à pointer selon une direction de consigne.

L'orientation de la charge utile 3 peut être contrôlée au moyen du dispositif de positionnement 1 lorsque la charge utile 3 est couplée mécaniquement au dispositif de positionnement 1.

Le dispositif de positionnement 1 comprend ainsi un axe de référence AA' dont la position angulaire est contrôlée au moyen du module de positionnement 7 et qui définit l'orientation de la charge utile 3 lorsque celle-ci est couplée au dispositif de positionnement 1.

La position angulaire de la charge utile 3 lorsqu'elle est couplée au dispositif de positionnement 1 est ainsi caractérisée par la position angulaire de l'axe de référence AA'.

La position de l'axe de référence AA' peut être précisée par la donnée des coordonnées géographiques d'un point de référence O par lequel passe l'axe de référence AA'.

La charge utile 3 est par exemple une antenne, notamment une antenne de télécommunication, une tête optronique, une caméra ou encore un canon.

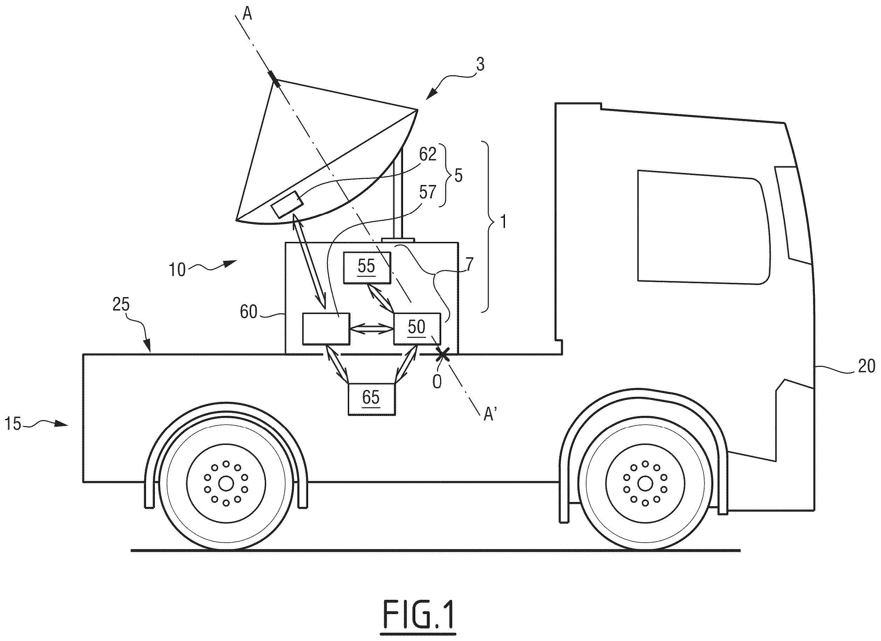

Dans un mode de réalisation particulier, la charge utile 3 est une antenne d'un système antennaire 10 de réception de signaux électromagnétiques, décrit en référence à la figure 1.

Dans ce mode de réalisation, le système antennaire 10 comprend l'antenne, qui constitue donc la charge utile 3, couplée avec le dispositif de positionnement 1.

Dans ce mode de réalisation, l'axe de référence AA' est la ligne de visée de l'antenne. A titre d'exemple, l'antenne est une antenne parabolique d'axe AA'.

Le système antennaire 10 est configuré pour la réception et/ou l'émission de signaux électromagnétiques.

A titre d'exemple non limitatif, le système antennaire 10 est un terminal de réception et/ou d'émission de signaux en provenance d'un (respectivement, vers un) satellite de télécommunications, notamment un satellite géostationnaire ou en orbite terrestre basse, communément appelé station « SatCom ».

Dans le cas où la charge utile 3 est une antenne, l'axe de référence AA' est donc à positionner de préférence :

- dans la direction d'une source S de signaux électromagnétiques dans le cas où l'antenne est réceptrice, et
- dans la direction d'un récepteur de signaux électromagnétiques dans le cas où l'antenne est émettrice.

Par souci de simplification, on décrit dans la suite le cas d'une antenne réceptrice, le cas d'une antenne émettrice pouvant en être déduit mutatis mutandis.

L'antenne est dans un mode de réalisation particulier à la fois réceptrice et émettrice.

La source S de signaux électromagnétiques est par exemple un satellite S, tel qu'un satellite géostationnaire.

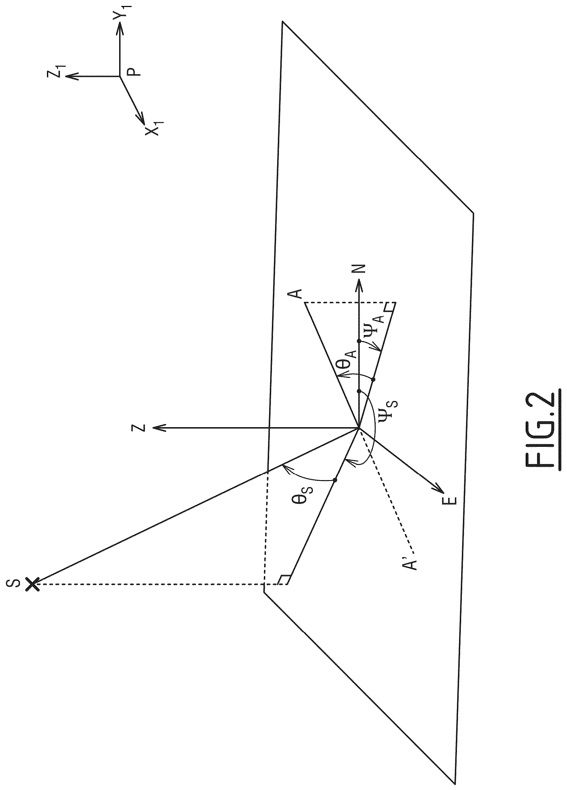

La position de la source S est repérée par son azimut $\psi(S)$ et son élévation $\theta(S)$ dans le système de coordonnées alt-azimutales local associé à la position géographique courante du point de référence O, représenté sur la figure 2.

De manière générale dans la présente description, l'élévation $\theta(M)$ d'un point M quelconque est l'angle formé entre le plan horizontal local OEN, où N désigne le nord géographique et E l'est, et la droite OM.

Sur la figure 2, Z désigne la direction du zénith, la droite OZ étant donc selon la direction verticale locale, relativement à la position courante du point de référence O.

L'azimut $\psi(M)$ du point M est défini dans la suite comme l'angle formé entre la direction du nord géographique ON et la projection de la droite OM dans le plan horizontal local OEN.

De manière générale, l'orientation souhaitée pour la charge utile 3 est repérée au moins par un azimut de consigne $\psi\_cons$, et optionnellement par une élévation de consigne $\theta\_cons$.

Comme indiqué précédemment, le module de positionnement 7 est configuré pour contrôler l'orientation de la charge utile 3 relativement au référentiel principal lorsque la charge utile est couplée au dispositif de positionnement 1, et en particulier pour asservir cette orientation à l'orientation de consigne.

A cette fin, le module de positionnement 7 comprend :

- une unité de contrôle 50 configurée pour recevoir des consignes de positionnement de la charge utile 3, les consignes de positionnement comprenant au moins l'azimut de consigne $\psi\_cons$ selon lequel la charge utile 3 doit être positionnée, et pour déterminer des instructions de positionnement de l'axe de référence AA' à partir des consignes de positionnement reçues et de données de mesure fournies par le magnétomètre 5,

- un dispositif d'actionnement mécanique 55 configuré pour modifier la position de l'axe de référence AA' relativement à une embase 60 sur la base des instructions de positionnement transmises par l'unité de positionnement 50, et
- un dispositif de couplage pour le couplage de la charge utile 3 avec l'axe de référence AA'.

Le dispositif d'actionnement mécanique 55 comprend par exemple un premier moteur de positionnement de l'axe de référence AA' selon l'azimut $\psi\_cons$ et optionnellement un deuxième moteur de positionnement de l'axe de référence AA' selon l'élévation $\theta\_cons$.

L'azimut de consigne $\psi\_cons$, et le cas échéant l'élévation de consigne $\theta\_cons$ sont par exemple l'azimut $\psi(S)$ et l'élévation $\theta(S)$ de la source S.

Le module de positionnement 7 est aussi configuré pour déplacer le magnétomètre 5 seul en l'absence de la charge utile 3, et conjointement avec la charge utile 3 lorsque la charge utile 3 est couplée au dispositif de positionnement 1.

Le magnétomètre 5 est donc configuré pour être mécaniquement solidaire de la charge utile 3 lorsque celle-ci est couplée au dispositif de positionnement 1.

En d'autres termes, le magnétomètre 5 est solidaire de l'axe de référence AA', de même que la charge utile 3 lorsqu'elle est couplée au dispositif de positionnement 1.

Le magnétomètre 5 comprend un élément sensible 62, sensible à la direction d'un champ magnétique auquel il est soumis, et un module de calibration 57 échangeant des données avec l'élément sensible 62 et avec l'unité de contrôle 50 du module de positionnement 7.

Le magnétomètre 5 est configuré pour fournir à l'unité de contrôle 50 des informations sur une direction locale du vecteur champ magnétique terrestre $\overrightarrow{B_{terr}}$, de manière à permettre une détermination de la direction locale ON du nord géographique, par rapport à laquelle les azimuts $\psi(M)$ - et éventuellement les élévations $\theta(M)$ - sont définis, pour une position courante du point de référence O, en vue de la détermination des instructions de positionnement de l'axe de référence AA' pour le positionnement de la charge utile 3.

De manière optionnelle, le magnétomètre 5 est en outre configuré pour fournir des informations sur une intensité locale du vecteur champ magnétique terrestre $\overrightarrow{B_{terr}}$. Dans ce cas, l'élément sensible 62 du magnétomètre 5 est en outre sensible à l'intensité d'un champ magnétique auquel il est soumis.

L'élément sensible 62 du magnétomètre 5 est configuré pour fournir au module de calibration 57 un vecteur champ magnétique mesuré $\overrightarrow{b_{mes}}$ représentatif de la direction et éventuellement de l'intensité d'un champ magnétique effectivement ressenti par l'élément sensible 62 du magnétomètre 5.

Le champ magnétique effectivement ressenti est la superposition du champ magnétique résultant du

champ magnétique terrestre $\overrightarrow{B_{terr}}$ et d'éventuels champs magnétiques générés par des sources de champs magnétiques permanents ou temporaires présentes dans l'environnement du magnétomètre 5, compte tenu d'éventuelles autres sources de perturbations magnétiques, telles que des matériaux ferromagnétiques doux présents dans le véhicule 15.

Le module de calibration 57 est en outre configuré pour recevoir des données de mesures auxiliaires d'un dispositif de mesure auxiliaire 65 et pour déterminer un vecteur de référence respectif $\overrightarrow{N_{REF}}$ représentatif de la direction du vecteur champ magnétique terrestre $\overrightarrow{B_{terr}}$ à une position de calibration $O_{cal}$ du point de référence O à partir des données de mesures auxiliaires.

Les données de mesures auxiliaires comprennent des données représentatives d'une direction du vecteur champ magnétique terrestre $\overrightarrow{B_{terr}}$ à la position de calibration $O_{cal}$ du point de référence O, et optionnellement d'une intensité de ce vecteur champ magnétique terrestre $\overrightarrow{B_{terr}}$.

Les données de mesures auxiliaires sont fournies au module de calibration 57 par le dispositif de mesure auxiliaire 65, qui est un dispositif de mesure distinct du magnétomètre 5 et configuré pour fournir des données de mesure représentatives de la direction du champ magnétique terrestre $\overrightarrow{B_{terr}}$ à une position d'acquisition $M_{aux}$ des données de mesure auxiliaire.

Le dispositif de mesure auxiliaire 65 est par exemple choisi parmi une antenne telle qu'une antenne de télécommunication, un récepteur de signaux de navigation par satellites et une centrale de navigation inertielle ou un magnétomètre de haute précision.

Le cas échéant, la centrale de navigation inertielle peut notamment être configurée pour fournir un cap magnétique et une position géographique au module de calibration 57 pour la détermination de la direction du champ magnétique terrestre $\overrightarrow{B_{terr}}$ à la position d'acquisition $M_{aux}$ par le module de calibration 57.

Le cas échéant, le récepteur de signaux satellites est par exemple un récepteur Dual GNSS et fournit deux mesures de positions géographiques au module de calibration 57 à partir desquelles le module de calibration détermine un cap magnétique représentatif de la direction du champ magnétique terrestre $\overrightarrow{B_{terr}}$ à la position d'acquisition $M_{aux}$.

Enfin, dans le cas où le dispositif de mesure auxiliaire 65 est une antenne d'un système antennaire 10, il est aussi possible de reconstituer la direction du champ magnétique terrestre $\overrightarrow{B_{terr}}$ à la position d'acquisition $M_{aux}$, et ce en particulier lorsque le système antennaire 10 est à l'arrêt.

Notamment, si l'antenne est directionnelle, ce qui est le cas dans le domaine des communications par satellites, un signal n'est effectivement reçu de la source S par l'antenne que si la position angulaire de l'antenne est assez proche de la direction de pointage sur cette source S, typiquement diffère de la direction de pointage de moins de quelques dixièmes de degré. Dès lors qu'un signal émis par la source S est effectivement reçu par l'antenne, la position angulaire de l'antenne, qui peut être déterminée au moyen d'informations fournies par des capteurs de position du dispositif d'actionnement mécanique 55, permet d'obtenir les données de mesure auxiliaire pour déterminer un cap magnétique, qui peut être améliorée au moyen d'algorithmes d'écartométrie connus de manière à être déterminée avec une précision de l'ordre de quelques centièmes de degrés. On comprend donc que dans ce cas, le dispositif de mesure auxiliaire 65 comprend l'antenne du système antennaire, c'est-à-dire la charge utile 3 elle-même, en combinaison avec le module de positionnement 7.

Sur la figure 1, le dispositif de mesure auxiliaire 65 a été représenté à titre illustratif de manière séparé de l'antenne formant la charge utile 3 mais on comprend à la lumière de ce qui précède que dans un mode de réalisation particulier de cet exemple, le dispositif de mesure auxiliaire 65 comprend cette même antenne, voire est constitué de cette même antenne.

Le dispositif de mesure auxiliaire 65 peut soit ne pas être embarqué dans le véhicule 15, soit être partiellement ou totalement embarqué dans le véhicule 15.

Le dispositif de mesure auxiliaire 65 est configuré pour échanger des données directement avec le module de calibration 57.

Le module de calibration 57 est configuré pour déterminer un modèle de calibration du magnétomètre 5 sur la base des données reçues du magnétomètre 5 et des données de mesures auxiliaires transmises par le dispositif de mesure auxiliaire 65.

A cette fin, le module de calibration 57 est réalisée au moins partiellement sous la forme d'un logiciel exécutable par un processeur et stocké dans une mémoire. En complément ou en variante, le module de calibration 57 est réalisé par exemple sous la forme d'un microcontrôleur MCU (en anglais, « MicroProcessingUnit »)) ou d'un processeur DSP (en anglais, « Digital Signal Processor »).

Le modèle de calibration est configuré pour fournir un vecteur corrigé $\overrightarrow{b_{corr}}$, représentatif d'une direction du vecteur champ magnétique terrestre $\overrightarrow{B_{terr}}$ pour une position de mesure $O_{mes}$ quelconque du point de référence O, à partir d'un vecteur mesuré $\overrightarrow{b_{mes}}$ acquis au moyen de l'élément sensible 62 du magnétomètre 5 et représentatif d'une direction du vecteur champ magnétique terrestre $\overrightarrow{B_{terr}}$ à la position de mesure $O_{mes}$ du point de référence O, l'axe de référence AA' étant alors selon une direction de mesure $D_{mes}$ donnée.

Le module de calibration 57 est configuré pour transmettre le vecteur corrigé $\overrightarrow{b_{corr}}$ au module de positionnement 7.

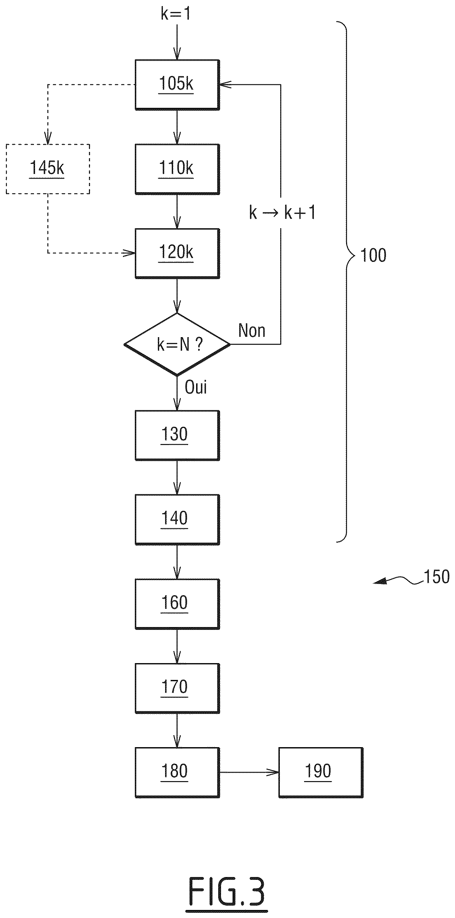

Le procédé de calibration 100 du magnétomètre 5 est décrit en référence à la figure 3.

Le procédé de calibration 100 comprend :

    a) pour une position de calibration $O_{cal}$ donnée du point de référence O dans le référentiel principal, et pour chacune d'une pluralité de directions de calibration $D_{cal,k}$ de l'axe de référence AA':

- la transmission 105k au module de positionnement 7 d'instructions de positionnement de l'axe de référence AA' selon la direction de calibration $D_{cal,k}$,
- l'acquisition 110k au moyen de l'élément sensible 62 du magnétomètre 5 d'un premier vecteur $\overrightarrow{b_{acq,k}}$ représentatif d'une direction du vecteur champ magnétique terrestre $\overrightarrow{B_{terr}}$ à la position de calibration $O_{cal}$, l'axe de référence AA' étant orienté selon la direction de calibration $D_{cal,k}$,
- la détermination 120k, sur la base de données de mesures auxiliaires obtenues avec le dispositif de mesure auxiliaire 65, d'un vecteur de référence respectif $\overrightarrow{N_{REF,k}}$ représentatif de la direction du vecteur champ magnétique terrestre $\overrightarrow{B_{terr}}$ à la position de calibration $O_{cal}$,

b) la détermination 130 du modèle de calibration du magnétomètre 5 sur la base de l'ensemble des premiers vecteurs $\overrightarrow{b_{acq,k}}$ et des vecteurs de référence $\overrightarrow{N_{REF,k}}$ respectifs obtenus pour chacune des directions de calibration $D_{cal,k}$, le modèle de calibration étant configuré pour fournir le vecteur corrigé $\overrightarrow{b_{corr}}$, représentatif de la direction du vecteur champ magnétique terrestre $\overrightarrow{B_{terr}}$ pour une position de mesure $O_{mes}$ quelconque du point de référence O à partir d'un vecteur mesuré $\overrightarrow{b_{mes}}$ acquis au moyen de l'élément sensible 62 du magnétomètre 5 et représentatif d'une direction du vecteur champ magnétique terrestre à la position de mesure, le point de référence O étant alors dans la position de mesure $O_{mes}$ et l'axe de référence AA' étant alors selon une direction de mesure $D_{mes}$ quelconque, et

c) la calibration 140 du magnétomètre 5 sur la base du modèle de calibration, le vecteur corrigé $\overrightarrow{b_{corr}}$ étant alors fourni en sortie du magnétomètre 5.

La transmission 105k est effectuée par le module de calibration 57.

La pluralité de directions de calibration $D_{cal,k}$ comprend N directions différentes, N étant un entier supérieur ou égal à 2, de préférence supérieur à 12, k étant un entier compris entre 1 et N.

Par exemple, les N directions de calibration $D_{cal,k}$ sont réparties, par exemple équiréparties, dans un angle solide effectivement accessible à l'axe de référence AA' du fait de la configuration du dispositif de positionnement 1 et de son éventuelle intégration dans le véhicule 15, qui déterminent un débattement angulaire de l'axe de référence AA' dans les différentes directions de l'espace.

Le nombre N de directions de calibration $D_{cal,k}$ et/ou leur répartition dans ledit angle solide peuvent être choisis en fonction d'une précision souhaitée pour le modèle de calibration et/ou d'un coût en temps et/ou en mémoire pour le module de calibration 57.

Comme on peut le voir sur la figure 3, les étapes de transmission 105k, d'acquisition 110k et de détermination 120k sont effectuées de manière itérative, le module de positionnement 7 positionnant pour cela l'axe de référence AA' successivement suivant chacune des directions de calibration $D_{cal,k}$ en réponse aux instructions de positionnement transmises successivement au cours des étapes de transmission 105k.

Lors de chaque étape d'acquisition 105k, le magnétomètre 5 acquiert au moyen de l'élément sensible 62 un premier vecteur $\overrightarrow{b_{acq,k}}$ respectif.

En l'absence de calibration préalable selon le procédé de calibration 100 selon l'invention ou encore si l'environnement direct du dispositif de positionnement 1 a été modifié après une calibration préalable selon le procédé de calibration 100, par exemple d'une modification dans le véhicule 15, le premier vecteur $\overrightarrow{b_{acq,k}}$ rend compte de la direction réelle du vecteur champ magnétique terrestre $\overrightarrow{B_{terr}}$ avec une incertitude qui peut être importante, notamment du fait des sources de perturbations magnétiques de l'élément sensible 62 du magnétomètre 5 présentes dans le véhicule 15.

Les étapes ultérieures du procédé de calibration 100 visent à réduire cette incertitude.

Chaque étape de détermination 120k est effectuée par le module de calibration 57. Pour cela, le module de calibration 57 détermine le vecteur de référence respectif $\overrightarrow{N_{REF,k}}$ représentatif de la direction du vecteur champ magnétique terrestre $\overrightarrow{B_{terr}}$ à la position de calibration $O_{cal}$ à partir des données de mesure auxiliaires fournies par le dispositif de mesure auxiliaire 65 à cette position de calibration $O_{cal}$.

Le vecteur de référence respectif $\overrightarrow{N_{REF,k}}$ est par exemple exprimé dans un repère d'espace lié à l'axe de référence AA', de sorte que son expression dépend des conditions dans lesquelles l'étape de détermination 120k respective est réalisée.

Par exemple, si le dispositif de mesure auxiliaire 65 est un magnétomètre de haute précision disponible à la position de calibration $O_{cal}$ de manière indépendante du véhicule 15, le vecteur de référence respectif $\overrightarrow{N_{REF,k}}$ peut être le vecteur champ magnétique mesuré directement par le dispositif de mesure auxiliaire 65 pour chacune des directions de calibration $D_{cal,k}$.

Alternativement, si le dispositif de mesure auxiliaire 65 est l'antenne du système antennaire 10, les données de mesure auxiliaire peuvent comprendre des données transmises via un signal balise émis par un satellite de télécommunication, par exemple une intensité du signal balise et des informations relatives à une direction de l'espace selon laquelle cette intensité est maximale.

Dans ce cas, le procédé de calibration 100 peut comprendre une étape additionnelle d'acquisition 145k comprenant l'acquisition des données de mesure auxiliaires avec le dispositif de mesure auxiliaire 65, l'antenne étant à la position de calibration $O_{cal}$, la ligne de visée de l'antenne étant, de même que l'axe de référence AA' avec laquelle elle est confondue, orientée selon la direction de calibration $D_{cal,k}$.

Dans ce cas, il est possible de reconstituer un cap vrai lorsque le véhicule 15 porteur du système antennaire 10 est à l'arrêt. La direction de pointage de l'antenne est connue avec une précision qui peut être de l'ordre du dixième de degré lorsque le signal émis et restituée à partir de capteurs de position du dispositif d'actionnement mécanique 55, de manière à reconstituer un cap magnétique à partir d'un signal balise reçu par l'antenne.

Chaque étape de détermination 120k peut être mise en œuvre avant la transmission 105(k+1) au module de positionnement 7 des instructions de positionnement selon la direction de calibration $D_{cal,k+1}$ suivante et/ou avant la mise en œuvre de ces instructions par le module de positionnement 7.

Alternativement, plusieurs étapes de détermination 120k, voire toutes les étapes de détermination 120k, peuvent être mises en oeuvre après plusieurs étapes d'acquisition 110k successives, voire après toutes les étapes d'acquisition 110k successives.

A l'issue de l'ensemble des étapes d'acquisition 110k et de détermination 120k, le module de calibration 57 détermine le modèle de calibration du magnétomètre 5.

La détermination du modèle de calibration comprend par exemple la détermination d'une matrice de calibration $H_{cal}$ et d'un vecteur de calibration $\overrightarrow{L_{cal}}$ tels que le vecteur corrigé $\overrightarrow{b_{corr}}$ et le vecteur mesuré $\overrightarrow{b_{mes}}$, quelle que soit la position de mesure $O_{mes}$ du point de référence O et la direction de mesure $D_{mes}$ de l'axe de référence AA', sont liés par une équation de la forme :

$$\overrightarrow{b_{corr}} = H_{cal}\ \overrightarrow{b_{mes}} + \overrightarrow{L_{cal}} \quad (1)$$

La matrice de calibration $H_{cal}$ est une matrice 3*3 et le vecteur de calibration $\overrightarrow{L_{cal}}$ est un vecteur colonne de dimension 3.

La matrice de calibration $H_{cal}$ et le vecteur de calibration $\overrightarrow{L_{cal}}$ sont par exemple déterminés par une méthode de régression telle que la méthode des moindres carrés à partir de l'ensemble des couples ($\overrightarrow{b_{acq,k}}$, $\overrightarrow{N_{REF,k}}$) acquis.

L'étape de calibration 140 comprend l'implémentation du modèle de calibration dans le magnétomètre 5 de manière à ce que le vecteur corrigé $\overrightarrow{b_{corr}}$ puisse être fourni sur une sortie du magnétomètre 5 lors d'une mesure ultérieure effectuée par le magnétomètre 5 et en particulier transmis au module de positionnement 7.

On comprend donc qu'une fois calibré selon le procédé de calibration 100, le magnétomètre 5 est apte à fournir un vecteur corrigé $\overrightarrow{b_{corr}}$ dont la précision est améliorée par rapport au vecteur mesuré $\overrightarrow{b_{mes}}$, puisque le modèle de calibration permet de prendre en compte de manière précise les anisotropies du magnétomètre 5 et de son environnement direct, en particulier du véhicule 15, grâce aux mesures effectuées selon chacune des directions de calibration, et ce, sans qu'aucune hypothèse forte sur le champ magnétique terrestre $\overrightarrow{B_{terr}}$ local à la position de calibration $O_{cal}$ ne soit nécessaire, puisque les mesures auxiliaires permettent d'éviter le recours à de telles hypothèses.

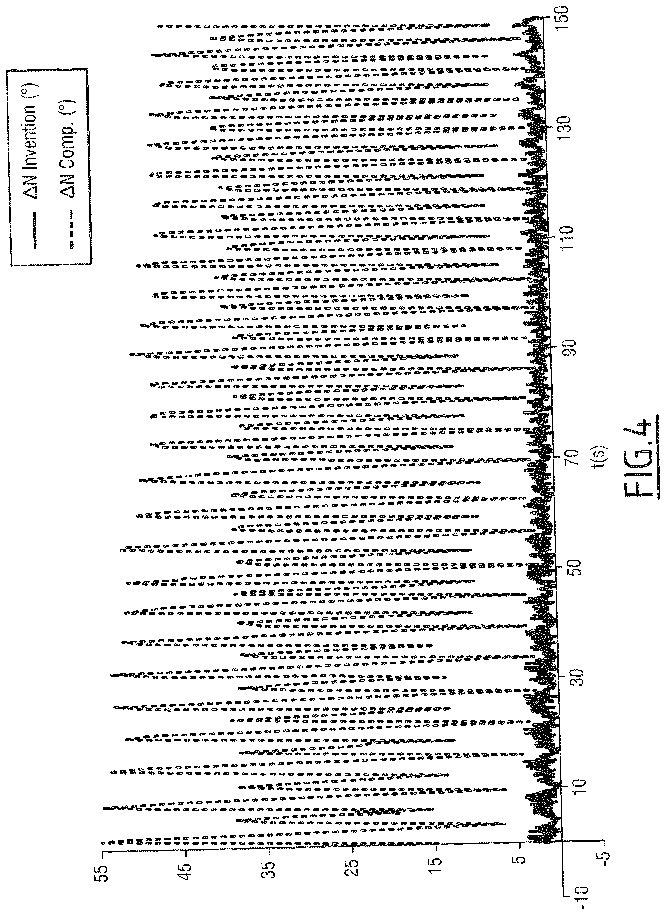

La figure 4 montre l'amélioration de précision permise par le procédé de calibration 100 selon l'invention.

Sur la figure 4, la courbe en trait plein représente l'écart angulaire ΔN_invention exprimé en degrés entre la direction du vecteur $\overrightarrow{b_{corr}}$ obtenu avec un système antennaire 10 comprenant un magnétomètre 5 de type MEMS et la direction du vecteur champ magnétique terrestre $\overrightarrow{b_{terr}}$ mesuré avec une centrale de navigation inertielle basée sur un gyrolaser, de fournissant un cap magnétique avec une précision de 0.1°, en fonction du temps t écoulé depuis le début de l'expérience exprimé en secondes. Le système antennaire 10 équipe pour ces mesures un véhicule 15 immobile et il comprend une antenne parabolique de 40 cm de diamètre. La gamme de positions accessibles à l'antenne est une demisphère. La vitesse de déplacement est de l'ordre de 0.5 rotations par minutes.

La courbe en trait pointillé représente l'écart angulaire ΔN_comp exprimé en degrés entre la direction du vecteur $\overrightarrow{b_{comp}}$ obtenu avec le même système antennaire 10 calibré selon un procédé de l'art antérieur, sur le principe décrit dans la publication E. M. Hemerly and F. A. A. Coelho, "Explicit Solution for Magnetometer Calibration," in IEEE Transactions on Instrumentation and Measurement, vol. 63, no. 8, pp. 2093-2095, Aug. 2014, doi: 10.1109/TIM.2014.2330446, et la direction du vecteur champ magnétique terrestre $\overrightarrow{B_{terr}}$ mesuré avec la même centrale de navigation inertielle en fonction du temps t écoulé depuis le début de l'expérience.

Les différents points de la courbe ont été obtenus en balayant l'ensemble de l'angle solide accessible à l'antenne de manière itérative sur la durée de l'expérience. Dans cet exemple, le dispositif d'actionnement mécanique à une course infinie en rotation autour de l'axe vertical OZ et une course limitée à la gamme [0, 100°] en rotation autour de l'axe horizontal E par rapport auquel est défini l'élévation.

On constate sur cette figure que le procédé de calibration 100 selon l'invention permet d'obtenir une incertitude sur le repérage de la direction du nord magnétique, et donc du nord géographique, inférieure à 5° dans toutes les positions accessibles à l'antenne, suffisante pour assurer l'accroche ou la poursuite d'un signal satellitaire avec le système antennaire 10.

Le procédé comparatif de l'art antérieur ne permet d'obtenir une incertitude inférieure à 5° que pour quelques positions, l'incertitude étant en moyenne de l'ordre de 25 ou 30°. Une telle incertitude n'est pas suffisante pour garantir la convergence d'un procédé de pointage de l'antenne dans de nombreux cas de figures.

Pour qu'une antenne de type Satcom détecte un signal émis par un satellite S, la précision de pointage de l'antenne doit être de l'ordre du degré. Il est connu de rallier un satellite même si cette erreur est légèrement supérieure en effectuant un balayage dans un angle solide approprié. Plus l'incertitude sur la direction de pointage est importante, plus l'angle solide à balayer est important, et en conséquence, plus le temps de ralliement de l'antenne SatCom vers un satellite est élevé. Pour de nombreuses applications, le temps de ralliement est un point clé de la performance d'une communication par satellite. On comprend donc que le procédé 100 selon l'invention, en améliorant la précision du pointage, permet de réduire le temps de ralliement d'un tel système antennaire 10.

Le modèle de calibration obtenu à l'étape de détermination 130 reste utilisable même si le véhicule 15 se déplace entre la position de calibration $O_{cal}$ et une position de mesure ultérieure $O_{mes}$.

Dans un mode de réalisation particulier, le procédé de calibration 100 peut être mis en œuvre de manière itérative.

Par exemple, le procédé de calibration est mis en œuvre à une position de calibration $O_{cal}$ à une position proche de, voire identique à une position de mesure ultérieure $O_{mes}$ prévue.

Ce mode de réalisation est notamment possible si le dispositif de mesure auxiliaire 65 est embarqué sur le véhicule 15.

Ce mode de réalisation permet notamment d'ajuster le modèle de calibration suite à d'éventuelles modifications de la configuration du véhicule 15 ou à un vieillissement des composants de la chaîne de mesure du magnétomètre 5.

L'invention porte aussi sur un procédé de pointage 150 de la charge utile 3 couplée au dispositif de positionnement 1 comprenant :

> i) la calibration du magnétomètre 5 dans une position de calibration $O_{cal}$ du point de référence O selon le procédé de calibration 100 décrit précédemment,
> ii) le positionnement 160 du point de référence O dans une position de pointage $O_{point}$, l'axe de référence AA' étant orienté selon une direction de mesure $D_{mes}$ quelconque,
> iii) la fourniture 170 d'une direction de pointage $D_{point}$ de la charge utile 3,
> iv) le positionnement 180 de l'axe de référence AA' selon la direction de pointage $D_{point}$ sur la base d'un vecteur corrigé $\overrightarrow{b_{corr}}$ fourni par le magnétomètre 5 à partir d'un vecteur mesuré $\overrightarrow{b_{mes}}$ respectif acquis au moyen de l'élément sensible 62 du magnétomètre 5, le point de référence O étant pour cette acquisition à la position de pointage $O_{point}$ et l'axe de référence AA' étant dans la direction de mesure $D_{mes}$, et optionnellement,

> v) dans le cas où la charge utile 3 est l'antenne du système antennaire 10, la réception de signaux électromagnétiques par l'antenne ainsi positionnée et si nécessaire, la modification du positionnement de l'orientation de l'antenne sur la base des signaux électromagnétiques reçus.

La position de pointage $O_{point}$ est une position d'utilisation souhaitée de la charge utile 3, par exemple de l'antenne du système antennaire 10 pour la réception de signaux électromagnétiques.

Le positionnement 160 du point de référence O de la charge utile 3 dans la position de pointage $O_{point}$ peut comprendre ou non un déplacement de la charge utile couplée au dispositif de positionnement 1 depuis la dernière position de calibration $O_{cal}$, par exemple par déplacement du véhicule 15.

La fourniture 170 de la direction de pointage $D_{point}$ de l'axe de référence AA' peut comprendre la fourniture à l'unité de contrôle 50 des consignes de positionnement, notamment d'un azimut de consigne $\psi\_cons$ et optionnellement d'une élévation de consigne $\theta\_cons$, tels que l'azimut $\psi(S)$ et l'élévation $\theta(S)$ d'un satellite à accrocher ou à poursuivre.

Pour le positionnement 180 de l'axe de référence AA', l'unité de contrôle 50 reçoit les consignes de positionnement et au moins une mesure fournie par le magnétomètre 5, par exemple la direction de pointage $D_{point}$ et le vecteur $\overrightarrow{b_{corr}}$, de manière à ensuite déterminer les instructions de positionnement à transmettre au dispositif d'actionnement mécanique 55 pour réaliser le positionnement souhaité de la charge utile 3.

Le vecteur $\overrightarrow{b_{corr}}$ étant déterminé avec une précision élevée, la précision sur le positionnement réel de la charge utile 3 par rapport à la direction de pointage $D_{point}$ donnée en consigne est améliorée.

De manière optionnelle, dans le cas où la charge utile 3 est l'antenne du système antennaire 10, le procédé de pointage comprend après le positionnement 180, la réception 190 de signaux électromagnétiques par l'antenne ainsi positionnée et si nécessaire, la modification du positionnement de l'axe de référence AA' sur la base des signaux électromagnétiques reçus.

Cette étape optionnelle permet d'améliorer encore le positionnement de l'antenne, après le premier positionnement 180, de précision accrue par rapport aux procédés de l'art antérieures grâce à la calibration selon l'invention, ou de positionner l'antenne dans le cas où les mesures auxiliaires ne seraient pas disponibles.

De manière générale, le procédé de calibration 100 selon l'invention permet de positionner rapidement et de manière précise une charge utile au moyen du dispositif de positionnement calibré par ce procédé.

Le procédé de calibration 100 et le procédé de pointage 150 permettent notamment d'améliorer les capacités de première accroche ou détection d'un signal satellitaire, de poursuite du signal satellitaire et/ou de réacquisition d'un signal satellitaire par le système antennaire 10 par rapport aux procédés de calibration de l'art antérieur à la fois :

- lorsque le véhicule 15 est immobile, avec un temps d'accroche par exemple de l'ordre de 5 secondes ou moins à comparer à plus d'une quinzaine de secondes dans le cas de l'art antérieur ; et
- lorsque le véhicule 15 est en mouvement, en faisant diminuer, voire disparaître, les cas d'absence de convergence du pointage vers un satellite, grâce à un pointage initial de précision améliorée.

**Revendications**

1. Procédé de calibration (100) d'un magnétomètre (5) d'un dispositif de positionnement (1) d'une charge utile (3), le dispositif de positionnement (1) comprenant un module de positionnement (7) configuré pour contrôler une orientation de la charge utile (3) relativement à un référentiel principal à partir de données fournies par le magnétomètre (5), le procédé comprenant :

   a) pour une position de calibration ($O_{cal}$) donnée d'un point de référence (O) du dispositif de positionnement (1) dans le référentiel principal, et pour chacune d'une pluralité de directions de calibration ($D_{cal,k}$) d'un axe de référence (AA') du dispositif de positionnement (1) :

   - la transmission (105k) au module de positionnement (7) d'instructions de positionnement de l'axe de référence (AA') selon la direction de calibration ($D_{cal,k}$),
   - l'acquisition (110k) au moyen d'un élément sensible (62) magnétomètre (5) d'un premier vecteur ($\overrightarrow{b_{acq,k}}$) représentatif d'une direction du vecteur champ magnétique terrestre ($\overrightarrow{B_{terr}}$) à la position de calibration ($O_{cal}$), l'axe de référence (AA') étant orienté selon la direction de calibration ($D_{cal,k}$), et
   - la détermination (120k), sur la base de données de mesures auxiliaires obtenues avec un dispositif de mesure auxiliaire (65), d'un vecteur de référence ($\overrightarrow{N_{REF,k}}$) respectif représentatif de la direction du vecteur champ magnétique terrestre à la position de calibration ($O_{cal}$),

   b) la détermination (130) d'un modèle de calibration du magnétomètre (5) sur la base de l'ensemble des premiers vecteurs ($\overrightarrow{b_{acq,k}}$) et des vecteurs de référence ($\overrightarrow{N_{REF,k}}$) respectifs obtenus pour chacune des directions de calibration ($D_{cal,k}$),

   le modèle de calibration étant configuré pour fournir un vecteur corrigé ($\overrightarrow{b_{corr}}$), représentatif d'une direction du vecteur champ magnétique terrestre ($\overrightarrow{B_{terr}}$) pour une position de mesure ($O_{mes}$) quelconque du point de référence (O) à partir d'un vecteur mesuré ($\overrightarrow{b_{mes}}$) acquis au moyen de l'élément sensible (62) du magnétomètre (5) et représentatif d'une direction du vecteur champ magnétique terrestre ($\overrightarrow{B_{terr}}$) à la position de mesure ($O_{mes}$),
   le point de référence (O) étant alors dans la position de mesure ($O_{mes}$) et l'axe de référence (AA') étant alors selon une direction de mesure ($D_{mes}$) quelconque, et

   c) la calibration (140) du magnétomètre (5) sur la base du modèle de calibration, le vecteur corrigé ($\overrightarrow{b_{corr}}$) étant alors fourni en sortie du magnétomètre (5).

2. Procédé de calibration (100) selon la revendication 1, dans lequel le dispositif de mesure auxiliaire (65) est un récepteur de signaux de navigation par satellites, les mesures auxiliaires étant obtenues au moyen dudit récepteur (65) de signaux de navigation et/ou de positionnement par satellites.

3. Procédé de calibration (100) selon la revendication 1, dans lequel le dispositif de mesure auxiliaire (65) est une centrale de navigation inertielle.

4. Procédé de calibration (100) selon la revendication 1, dans lequel la charge utile (3) est une antenne de télécommunication, le dispositif de mesure auxiliaire (65) comprenant ladite antenne.

5. Procédé de calibration (100) selon l'une quelconque des revendications précédentes, dans lequel les directions de calibration ($D_{cal,k}$) sont équidistribuées dans un angle solide accessible à l'axe de référence (AA').

6. Procédé de calibration (100) selon l'une quelconque des revendications précédentes, dans lequel la détermination du modèle de calibration comprend la détermination d'une matrice de calibration ($H_{cal}$) et un vecteur de calibration ($\overrightarrow{L_{cal}}$) tels que le vecteur corrigé et le vecteur mesuré sont liés par une équation de la forme :

$$\overrightarrow{b_{corr}} = H_{cal}\ \overrightarrow{b_{mes}} + \overrightarrow{L_{cal}}$$

où $\overrightarrow{b_{corr}}$ désigne le vecteur corrigé, $\overrightarrow{b_{mes}}$ désigne le vecteur mesuré, $H_{cal}$ désigne la matrice de calibration et $\overrightarrow{L_{cal}}$ désigne le vecteur de calibration.

7. Procédé de pointage (150) d'une charge utile (3) couplée à un dispositif de positionnement (1) comprenant un magnétomètre (5) et un module de positionnement (7) configuré pour contrôler l'orientation de la charge utile (3) relativement à un référentiel principal à partir de données issues de mesures du magnétomètre (5), le procédé de pointage comprenant :

i) la calibration du magnétomètre (5) selon le procédé de calibration (100) selon l'une quelconque des revendications précédentes,
ii) le positionnement (160) du point de référence (O) du dispositif de positionnement (1) dans une position de pointage ($O_{point}$),
iii) la fourniture (170) d'une direction de pointage ($D_{point}$) de la charge utile (3),
iv) le positionnement (180) de l'axe de référence (AA') du dispositif de positionnement (1) selon la direction de pointage ($D_{point}$) sur la base d'un vecteur corrigé ($\overrightarrow{b_{corr}}$) fourni par le magnétomètre (5) à partir d'un vecteur mesuré ($\overrightarrow{b_{mes}}$) respectif acquis au moyen de l'élément sensible (62) du magnétomètre (5), le point de référence (O) étant pour cette acquisition à la position de pointage ($O_{point}$) et l'axe de référence (AA') étant dans une direction de mesure ($D_{mes}$) quelconque.

8. Procédé de pointage (150) selon la revendication 7, dans lequel la charge utile (3) est une antenne d'un système antennaire (10) de télécommunication et la fourniture de la direction de pointage ($D_{point}$) de la charge utile (3) comprend la fourniture d'un azimut ($\psi(S)$) d'un satellite de télécommunication.

9. Dispositif de positionnement (1) d'une charge utile (3), configuré pour contrôler une orientation de la charge utile (3) relativement à un référentiel lorsque la charge utile (3) est couplée au dispositif de positionnement (1), le dispositif de positionnement (1) comprenant :

- un magnétomètre (5), et
- un module de positionnement (7) configuré pour contrôler l'orientation de la charge utile (3) qui serait couplée au dispositif de positionnement (1) relativement à un référentiel principal à partir de données issues de mesures du magnétomètre (5),

le dispositif de positionnement étant en outre configuré pour mettre en œuvre le procédé de calibration (100) selon l'une quelconque des revendications 1 à 6.

10. Système antennaire (10) configuré pour la réception et/ou l'émission de signaux électromagnétiques comprenant une antenne et un dispositif de positionnement (1) selon la revendication 9 auquel l'antenne est couplée en tant que charge utile (3).

11. Véhicule (15) équipé d'un système antennaire (10) de réception et/ou d'émission de signaux électromagnétiques selon la revendication 10.

FIG.1

EP 4 764 408 A1

FIG.2

FIG.3

FIG.4

EP 4 764 408 A1

Europäisches Patentamt
European Patent Office
Office européen des brevets

# RAPPORT DE RECHERCHE EUROPEENNE

Numéro de la demande

EP 25 22 5152

## DOCUMENTS CONSIDERES COMME PERTINENTS

| Catégorie | Citation du document avec indication, en cas de besoin, des parties pertinentes | Revendication concernée | CLASSEMENT DE LA DEMANDE (IPC) |
|---|---|---|---|
| X | US 2019/094023 A1 (DIEM FABIO [CH] ET AL) 28 mars 2019 (2019-03-28) | 1,3,5-7, 9 | INV. G01C17/38 |
| Y | * alinéas [0037], [0038], [0042], [0048], [0056], [0057], [0062], [0067]; figures 5A,5B * | 2,4,8, 10,11 | G01C21/16 G01R33/00 |
| | ----- | | |
| Y | CN 101 699 220 A (NANJING CHINA SPACENET TELECOM) 28 avril 2010 (2010-04-28) * le document en entier * | 2,4,8, 10,11 | |
| | ----- | | |

**DOMAINES TECHNIQUES RECHERCHES (IPC)**

G01C
G01R

Le présent rapport a été établi pour toutes les revendications

| Lieu de la recherche | Date d'achèvement de la recherche | Examinateur |
|---|---|---|
| La Haye | 27 mars 2026 | de la Rosa Rivera, E |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons
................................................................
& : membre de la même famille, document correspondant

EPO FORM 1503 03.82 (P04C02)

## ANNEXE AU RAPPORT DE RECHERCHE EUROPEENNE
## RELATIF A LA DEMANDE DE BREVET EUROPEEN NO.

EP 25 22 5152

La présente annexe indique les membres de la famille de brevets relatifs aux documents brevets cités dans le rapport de recherche européenne visé ci-dessus.
Lesdits members sont contenus au fichier informatique de l'Office européen des brevets à la date du
Les renseignements fournis sont donnés à titre indicatif et n'engagent pas la responsabilité de l'Office européen des brevets.

27-03-2026

| Document brevet cité au rapport de recherche | Date de publication | Membre(s) de la famille de brevet(s) | Date de publication |
|---|---|---|---|
| US 2019094023 A1 | 28-03-2019 | US 2018112980 A1<br>US 2019094023 A1 | 26-04-2018<br>28-03-2019 |
| CN 101699220 A | 28-04-2010 | AUCUN | |

EPO FORM P0460

Pour tout renseignement concernant cette annexe : voir Journal Officiel de l'Office européen des brevets, No.12/82

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Littérature non-brevet citée dans la description**

- **E. M. HEMERLY** ; **F. A. A. COELHO**. Explicit Solution for Magnetometer Calibration. *IEEE Transactions on Instrumentation and Measurement*, August 2014, vol. 63 (8), 2093-2095